# FASCICULE DE BREVET EUROPEEN

(11) **EP 2 862 424 B1**
(45) Date de publication et mention de la délivrance du brevet: **11.09.2019**
(21) Numéro de dépôt: 13729015.1
(22) Date de dépôt: 12.06.2013
(51) Int. Cl.: H05K 1/18, H05K 3/06, H05K 3/40

(54) **PROCEDE DE REALISATION DE CIRCUIT ELECTRONIQUE A PROTECTION DE COUCHE CONDUCTRICE**
VERFAHREN ZUR HERSTELLUNG EINER ELEKTRONISCHEN SCHALTUNG MIT SCHUTZ DER LEITENDEN SCHICHT
METHOD OF PRODUCING AN ELECTRONIC CIRCUIT WITH PROTECTION OF THE CONDUCTIVE LAYER

(30) Priorité: 14.06.2012 FR 1201701
(43) Date de publication de la demande: 22.04.2015
(73) Titulaire: Linxens Holding, 78280 Guyancourt (FR)
(72) Inventeur: DIEU-GOMONT, Séverine, F-78270 Limetz-Villez (FR); LECHLEITER, François, F-78200 Favrieux (FR); DE MAQUILLÉ, Yannick, F-78100 Saint-Germain-en-Laye (FR)
(74) Mandataire: Regi, François-Xavier
(86) Numéro de dépôt international: PCT/EP2013/062091
(87) Numéro de publication internationale: WO 2013/186241

(56) Documents cités:
- WO-A1-03/026010
- US-A- 3 480 836
- US-A- 5 433 819
- US-A- 6 014 805
- US-A1- 2009 266 788

## Description

L'invention concerne la réalisation de circuits électroniques, notamment de circuits imprimés.

Elle concerne notamment la réalisation de tels circuits lorsqu'ils portent un ou plusieurs composants lesquels composants présentent des contacts sur une face destinée à être positionnée en vis-à-vis de pistes conductrices du circuit pour contacter de telles pistes sans liaison filaire intermédiaire, ces composants étant également appelés « flip chip » dans la terminologie anglophone.

L'invention concerne également la réalisation de circuits électroniques, notamment de circuits imprimés, portant un ou plusieurs composants lesquels composants présentent des contacts sur une face et où ces contacts sont destinés à être reliés électriquement à des pistes conductrices du circuit pour contacter de telles pistes par des liaisons filaires intermédiaires respectives s'étendant du contact jusqu'à la piste conductrice, ou composants de type wire-bonding selon la terminologie anglophone.

L'invention concerne notamment la réalisation de tels circuits électroniques de type flexibles.

L'invention concerne notamment la réalisation de tels circuits lorsque les composants sont des composants émetteurs de lumière tels que des diodes électroluminescentes - ou LEDs pour Light Emitting Diode en Anglais - Pour réaliser un tel circuit, il est possible de prévoir un support constitué notamment d'un film diélectrique et d'une feuille de cuivre laminés ensemble. Le film diélectrique est pré-perforé avant laminage pour comporter un certain nombre de fenêtres destinées à recevoir chacune un ou plusieurs composants de telle sorte que le ou les composants sont placés au fond d'une cavité délimitée par la fenêtre du film diélectrique. US3480836 divulgue un tel arrangement.

Pour la réalisation d'un tel circuit, il est en outre nécessaire de ménager des sillons dans la couche de cuivre et notamment dans une portion de la couche de cuivre qui forme le fond de la cavité. De tels sillons ont pour rôle notamment de séparer électriquement différents plages du fond de la cavité, telles qu'une plage connectée à un contact formant l'anode du composant et une plage connectée à un contact formant la cathode du composant. De tels sillons en fond de cavité servent également à délimiter des pistes électriques reliant différents organes du circuit tels que le composant placé dans la cavité ou d'autres composants du circuit.

On souhaite selon l'invention proposer un procédé de réalisation d'un tel circuit électronique notamment flexible qui permette de réaliser de tels sillons dans une étape postérieure au laminage de la couche conductrice avec le film diélectrique, et dans lequel l'étape de réalisation des sillons ne génère aucun endommagement d'une face de la couche conductrice située au fond de la cavité de sorte que le composant puisse être fixé et connecté sur cette face de manière fiable.

Ce but est atteint selon l'invention grâce à un procédé de réalisation de circuit comprenant un support lequel support comprend une couche conductrice et un film diélectrique laminés entre eux, le procédé incluant une étape de réalisation de fenêtres dans le film diélectrique de sorte que le support forme des cavités ayant une paroi de fond constituée par la couche conductrice et des bordures constituées par le film diélectrique, le procédé incluant l'étape consistant à venir placer contre la paroi de fond d'une cavité et connecter à la paroi de fond un composant électronique, le procédé comprenant l'étape consistant à graver des sillons dans la couche conductrice, cette étape de gravure de la couche conductrice étant réalisée postérieurement au laminage de la couche conductrice avec le film diélectrique à l'aide d'une solution de gravure et le procédé comprenant une étape préliminaire à l'étape de gravure, laquelle étape préliminaire consiste à déposer une couche de matériau de protection sur la couche conductrice dans le fond de la cavité et sur au moins une partie du film diélectrique formant les bordures de la cavité, lequel matériau de protection est un matériau liquide apte à durcir et résistant une fois durci à la solution de gravure mise en oeuvre lors de l'étape de gravure de la couche conductrice.

Avantageusement, l'étape consistant à venir placer un composant électronique contre la paroi de fond d'une cavité et à connecter à la paroi de fond le composant électronique comprend le fait de mettre en connexion le composant électronique avec la paroi de fond sans liaison filaire intermédiaire.

Avantageusement, l'étape consistant à venir placer un composant électronique contre la paroi de fond d'une cavité et à connecter à la paroi de fond le composant électronique comprend le fait de connecter le composant électronique à la paroi de fond par une liaison filaire laquelle s'étend du composant électronique à la paroi de fond.

Avantageusement, le composant électronique est un composant électroluminescent.

Avantageusement, le matériau de protection est une encre.

Avantageusement, le matériau de protection est une résine.

Avantageusement, le matériau de protection est une mélange d'au moins une encre et d'au moins une résine.

Avantageusement, le matériau de protection fait partie du groupe constitué des polyuréthanes mono ou bi-composants, des résines acryliques ou méthacryliques, des résines acryliques réticulables aux ultra-violets, des copolymères styrène anhydride maléique, des copolymères styrènes acrylique, des copolymères acryliques méthacryliques, des résines formol phénol, des résines novolaque, des résines époxy.

Avantageusement, le matériau de protection est un matériau apte à être durci par exposition à la lumière et le procédé comprend l'étape consistant à exposer le matériau de protection à la lumière pour le durcir.

Avantageusement, le procédé comprend une étape postérieure à l'étape de gravure qui consiste à enlever la couche de matériau de protection.

Avantageusement, l'étape consistant à enlever la couche de matériau de protection consiste à plonger le support dans un bain de solution d'attaque chimique de la couche de matériau de protection.

Avantageusement, le matériau de protection est appliqué par une opération faisant partie du groupe constitué d'une pulvérisation, d'une enduction, d'une impression.

Avantageusement, le circuit est un circuit de type flexible.

D'autres caractéristiques, buts et avantages de l'invention apparaitront à la lecture de la description qui va suivre, faite en référence aux figures annexées sur lesquelles :
- La figure 1 représente un support selon un mode de réalisation de l'invention dans une première étape de réalisation ;
- La figure 2 représente ce même support après dépôt d'une couche de matériau de protection ;
- La figure 3 représente ce même support après mise en place d'un film photo-imagé de protection contre une gravure chimique ;
- La figure 4 représente ce même support après réalisation de sillons dans une couche conductrice de ce support ;
- La figure 5 représente ce même support après mise en place d'un composant luminescent sur ce dernier.

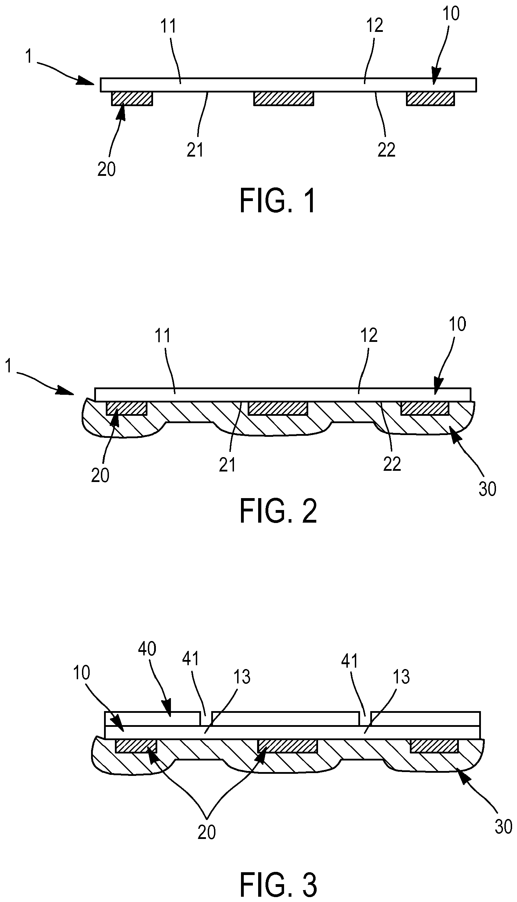

Tel que représenté à la figure 1, un support 1 de circuit électronique est ici constitué d'une feuille de cuivre 10 et d'un film diélectrique 20 laminés entre eux. Le film diélectrique 20 et la feuille de cuivre sont d'une épaisseur suffisamment faible pour que le support 1 soit de type flexible. En particulier, le film diélectrique 20 et la feuille de cuivre se présentent avant laminage sous forme de rouleaux et on décrira maintenant différentes étapes de traitement qui seront préférentiellement réalisées par déroulage et enroulage d'un rouleau d'une telle feuille, film ou support, permettant ainsi une vitesse d'implémentation particulièrement élevée du procédé qui sera décrit maintenant.

Le film diélectrique 20 est ici un film de verre époxy, lequel a subi une étape d'encollage sur une face supérieure puis une étape de perforation avant d'être laminé avec la couche de cuivre 10. Les perforations forment ici deux fenêtres 21, 22 dans le film 20 pour recevoir chacune un composant que l'on décrira par la suite et qui sera dans le présent exemple un composant luminescent. Les fenêtres, ici représentées au nombre de deux pour des raisons de simplicité de l'exposé, sont préférentiellement réparties de manière homogène pour une répartition également homogène d'une lumière dégagée par les composants luminescents.

Dans le mode de réalisation décrit maintenant, le composant luminescent est un composant à semi-conducteur de type puce nue, ou bare chip en Anglais.

Une telle puce nue est également appelée dé ou « dice » en Anglais, de par le procédé industriel typiquement utilisé pour obtenir une telle puce nue. Un tel procédé consiste à produire de larges lots d'un même circuit intégré lequel est constitué d'éléments de tracés de diffusion ayant une configuration choisie sur une surface d'un substrat ou « wafer » en anglais. Le wafer est ensuite découpé en petites pièces formant chacune un exemplaire du circuit. Chacune de ces pièces constitue donc un « dé » ou « dice » en Anglais. La puce nue ou bare chip en Anglais est constituée d'un substrat sur lequel est déposée une succession de couches semi-conductrices, laquelle succession de couches semi-conductrices a la capacité d'émettre de la lumière lorsqu'une différence de potentiel est appliquée entre deux couches spécifiques de cette succession de couches. Une telle puce nue présente typiquement une largeur de quelques dizaines de micro-mètres et une telle puce nue a des plages de contact d'une largeur de quelques dizaines de micro-mètres, typiquement entre 50 et 100 micromètres.

La présente puce nue est ici une puce basculée ou puce « flip chip » selon la terminologie anglophone, laquelle comporte des plages de contact sur une face de la puce destinée à être positionnée en vis-à-vis de pistes d'un circuit de sorte que la puce est mise en connexion avec ces pistes conductrices sans liaison filaire intermédiaire, typiquement par l'intermédiaire d'une pâte de brasage.

Dans un autre mode de réalisation, la puce nue est connectée aux pistes du circuit par des liaisons filaires lesquelles s'étendent à chaque fois depuis un contact de la puce et jusqu'à une piste correspondante du circuit, selon la technologie connue sous le nom de « wire bonding » selon la terminologie anglophone, les liaisons filaires étant par exemple soudées aux pistes du circuit.

Dans un autre mode de réalisation, le composant luminescent est un composant à montage en surface ou SMC pour Surface Mount Component selon la dénomination anglophone.

La technologie de montage en surface, connue sous le sigle SMT pour Surface Mount Technology en Anglais, est un procédé de construction de circuits électroniques dans lequel les composants montés en surface - habituellement appelés SMCs pour Surface Mount Components en Anglais sont montés directement sur la surface d'un circuit. Un dispositif électronique ainsi réalisé est appelé un dispositif à montage en surface ou SMD pour Surface Mounted Device en Anglais.

Un SMC comprend un substrat et une puce nue similaire à celle décrite ci-dessus. La puce nue est fixée sur une première face du substrat, et le substrat comportant des plages conductrices sur une seconde face du substrat. Les plages conductrices de la puce nue sont connectées aux plages conductrices du substrat au moyen de liaisons filaires. Un corps d'encapsulage est surmoulé sur la puce nue et sur les liaisons filaires de sorte que le SMC forme un composant protégé et robuste pouvant être facilement et directement monté sur un support muni de pistes conductrices. Un SMC a une taille typiquement de l'ordre d'un demi-millimètre. Les plages conductrices d'un SMC ont une taille typiquement de l'ordre de quelques centaines de micromètres. On utilise ici un tel SMC qui soit de type flip chip ou puce basculée en Français, de sorte que le SMC est placé dans une fenêtre 21, 22 avec ses plages de contact placées en vis-à-vis de pistes conductrices constituées par la couche de cuivre 10 et connectées à celle-ci sans liaison filaire intermédiaire.

Dans une variante, le SMC est placé dans la cavité et connecté aux pistes conductrices constituées par la couche de cuivre 10 par l'intermédiaire de liaisons filaires. Dans ce cas, on place avantageusement le SMC de telle sorte que ses contacts sont dirigés dans une direction d'éloignement de la couche de cuivre 10. Les liaisons filaires sont avantageusement soudées à la fois aux contacts du SMC et aux pistes conductrices constituées par la couche de cuivre 10.

Afin de réaliser de telles pistes dans la couche de cuivre, on réalise des sillons dans celle-ci, le support 1 formant alors la partie imprimée du circuit imprimé à réaliser. Ainsi et aux fins d'une simplicité de la représentation, on réalise ici un sillon dans chaque cavité 21, 22 lequel sillon est destiné à constituer une séparation électrique dans la couche de cuivre 10 entre une portion venant au contact d'une anode du composant et une portion venant au contact d'une cathode du composant.

De tels sillons sont ici réalisés par une gravure chimique de la couche de cuivre, ici à l'aide d'un réactif de gravure chimique connu en soi à base de chlorure cuivrique et comprenant de l'acide chlorhydrique.

Chaque cavité 21,22 présente une paroi de fond respective 11, 12 constituée par une portion de la couche de cuivre 10 qui n'est supportée par aucun substrat, laquelle portion de couche de cuivre formant la paroi de fond est donc nue sur ses deux faces et exposée dans cet état à une attaque de la solution de gravure chimique.

Avant d'être plongée dans un bain d'un tel réactif de gravure, la couche de cuivre 10 sera protégée sur sa face située du côté opposé à celle portant le film diélectrique 20, dans ses zones complémentaires à celles devant être gravées. Une telle protection sera réalisée par dépôt, insolation, développement puis nettoyage d'un film de protection photosensible.

Néanmoins, une telle technique de réalisation de sillons permet certes de protéger une face de la couche de cuivre 10 qui est orientée à l'inverse du film diélectrique 20, mais ne permet pas de protéger la face de la couche de cuivre positionnée vers le film diélectrique 10 et notamment de protéger les portions de la couche de cuivre 10 formant les fonds des cavités 21 et 22.

On pourrait certes envisager de protéger cette face du support par un dépôt de film photosensible classique, mais une telle technique serait inadaptée dans une pareille configuration. D'abord, les films photosensibles connus ne permettent qu'une adhésion faible et donc peu fiable sur le matériau formant la couche diélectrique 20. Ensuite un espace resterait entre le film diélectrique et le fond 11, 12 de chaque cavité 21, 22, dans lequel la solution de gravure risquerait de pénétrer après que la solution ait creusé le sillon sur l'ensemble de l'épaisseur de la couche de cuivre, la solution venant endommager la face de la couche de cuivre formant le fond de la cavité, laquelle face doit rester intacte et plane pour recevoir le composant.

On protège ici la face de la couche de cuivre 10 formant le fond des cavités 21, 22 selon la technique suivante, qui va être décrite maintenant en référence à la figure 2.

Dans une étape de protection représentée à la figure 2, on dépose sur la face du support 1 formant les cavités 21, 22, une couche liquide 30 laquelle est ici constituée d'une encre pouvant durcir et résistant, une fois durcie, au réactif de gravure utilisé par la suite pour graver les sillons.

Une telle encre résistante à la gravure ou encre « etch resist » en Anglais présente l'avantage, de par sa forme liquide, de venir épouser plus facilement toute forme de paroi et donc d'assurer ici le remplissage des cavités à protéger.

Une telle encre « etch resist » peut être un encre photosensible ou non.

L'encre utilisée est préférentiellement enlevable ou « strippable » en Anglais par utilisation d'une solution spécifique d'attaque ou de « strippage » en Anglais agissant sur une telle encre. L'encre utilisée est ainsi préférentiellement « strippable » en milieu alcalin ou solvanté.

Différentes techniques peuvent être utilisées pour appliquer l'encre liquide, telles qu'une enduction par exemple par rouleau, au rideau, ou encore à l'aide d'une buse de type à impression par fente ou « slot die » selon la terminologie Anglophone.

L'encre peut être appliquée par impression, comme par exemple par une application par sérigraphie, , par jet d'encre, ou par technique « offset » selon la terminologie Anglophone, etc. La méthode d'application de l'encre est choisie en fonction des caractéristiques et de la viscosité de l'encre utilisée.

En variante le matériau de protection appliqué sous forme liquide et résistant à la gravure chimique une fois durci peut être une résine, ou encore un mélange d'encre et de résine. Une telle couche de protection peut ainsi être choisie pour être durcissable par exposition à la lumière ou non.

Des familles chimiques adéquates sont les polyuréthanes mono ou bi-composants, les résines acryliques ou méthacryliques qui peuvent être hydroxylées ou carboxylées, les résines acryliques réticulables aux ultra-violets, les copolymères styrène anhydride maléique, les copolymères styrènes acrylique, les copolymères acryliques méthacryliques, les résines formol phénol, les résines novolaque ou résine de phénolformaldéhyde, etc ....

De telles encres ou résines sont disponibles sur le marché par exemple sous les références et marques de APR-68 de la société Atotech, Probimage 120 de la société Huntsman, XV750 Imageline Etch Resist Family de la société Coates, Photoposit SN68H, SP 24 de la société Rohm and Haas, AS500-LY de la société Taiyo Ink, ETP 240RC, ETAV 24 de la société Electra Polymers Ltd, ELPEMER RC2054 HR de la société Peters SMA1440F resin de la société Arkema, Joncryl 678 de la société BASF, Alnovol PN 160 de la société Cytec, etc...

Le strippage peut être réalisé avec une solution alcaline aqueuse, par exemple une solution de soude ou de potasse à 2% ou un solvant de la famille des cétones, des esters ou des alcools tel que l'acétone, le méthyl éthyl cétone, l'acétate d'éthyle, l'éthanol, etc.

Tel que représenté à la figure 3, une couche de protection 40 est ensuite ménagée sur la face de la couche de cuivre 10 qui est disposée à l'opposé de la couche diélectrique 20, selon une technique connue en soi de dépôt de film photosensible ou de laque photosensible, insolation de ce film ou de cette laque selon une topographie souhaitée, développement puis retrait chimique des zones non insolées.

Le film de protection 40 présente au final la configuration représentée à la figure 3, où il présente des ouvertures 41 qui laissent exposées des zones 13 de la couche de cuivre 10 en face opposée à celle portant la couche di-électrique 20.

La gravure est ensuite réalisée en plongeant cet ensemble dans le bain de solution de gravure. La solution pénètre alors dans les ouvertures 41 du film de protection 40 et creuse un sillon 14 dans la couche de cuivre 10, ici en position centrale des cavités 21, 22.

La solution de gravure traverse la couche de cuivre 10 et atteint alors la couche de matériau de protection 30, où elle est stoppée de sorte qu'elle ne peut pas atteindre la face opposée de la couche de cuivre 10 formant le fond de la cavité considérée 21, 22.

La face de la couche de cuivre 10 formant le fond de la cavité 21, 22 est ainsi protégée de toute altération par la solution de gravure et reste intacte pour le positionnement, la fixation et la mise en contact du composant.

Une étape suivante consiste en un retrait du film de protection photo-imagé 40 et de la couche de matériau de protection 30, par plongeon dans des bains de strippage adaptés à chacun des matériaux constituant ces couches 30 et 40.

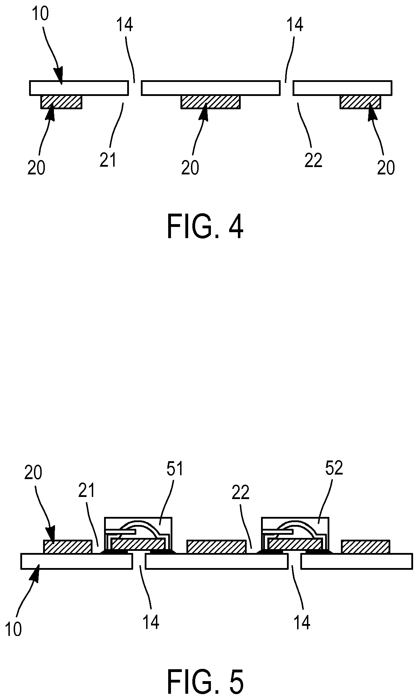

L'ensemble obtenu, représenté à la figure 4, consiste alors en un support ayant une série de cavités 21,22 chacune munie d'un sillon central 14 séparant deux plages de contact respectives du fond de la cavité considérée.

Bien entendu, de multiples tracés de sillons de fond de cavité peuvent être envisagés, tels que des tracés rectilignes, courbes, en T, en S, etc..

Tel que représenté sur la figure 2, le matériau de protection 30 épouse le fond de la cavité formé par la couche de cuivre 10 ainsi que les bords de la cavité formés par les bords des fenêtres du film diélectrique 20. Le matériau de protection 30 vient notamment adhérer à la couche de cuivre dans une zone du fond de la cavité 21, 22 où doit être réalisée le sillon. Ainsi, l'utilisation de matériau « etch resist » liquide pour protéger le fond de la cavité rend cette technologie très flexible et permet de s'adapter à de nombreuses configurations de produits.

Bien que dans le présent exemple les cavités aient une largeur située entre 650µm et 2.8mm, le procédé est adaptable à de cavités nettement plus vastes ou nettement plus restreintes. Le procédé est également adaptable à des variations de la forme des cavités à protéger telles que des formes carrées, rectangulaires, circulaires, ainsi qu'à des variations de nombre et/ou de densité des cavités à protéger et donc à des espaces variés entre les cavités. Dans le présent mode de réalisation, les espaces entre cavités adjacentes est par exemple situé entre 1.5 mm et 9.5 mm, correspondant à un nombre de cavités allant de 6 à 18 cavités pour une largeur ayant une valeur de 70 mm.

Le procédé est également adapté à des variations de l'épaisseur du film diélectrique 20 et donc de la profondeur des cavités 21, 22 à remplir. Dans le présent exemple, les cavités 21, 22 ont une épaisseur de 200µm. Le procédé est également adapté à des variations de l'épaisseur de la couche de cuivre 10 à protéger et donc des paramètres utilisés en gravure, la couche de cuivre pouvant être par exemple une feuille de cuivre de 35 ou 70µm d'épaisseur. Le procédé est également adapté à des variations de la forme du sillon ou ici l'inter-piste à graver, ce sillon pouvant être par exemple en ligne droite, en « S », en « T » ou toute autre forme de ligne.

Une des difficultés principales réside dans la possibilité d'assurer le remplissage sans bulles des cavités avec l'encre résistante à la gravure. En effet, en cas de présence de bulles, le rôle de protection temporaire à la gravure peut ne pas être complétement assuré car le dépôt d'encre présente une résistance mécanique moindre au jet de bain de gravure au niveau des bulles.

L'ensemble obtenu est ensuite soumis à une opération de dépôt de couche de finition sur la face du support 1 où se trouve la couche diélectrique 20. Une couche métallique de finition vient ainsi recouvrir à la fois la couche de cuivre 10 dans le fond des cavités 21, 22 et la couche di-éléctrique 20 dans ses parties exposées, c'est-à-dire à la fois dans ses zones s'étendant dans le plan principal du support 1 et dans ses zones formant les bordures verticales des cavités 21, 22. La couche de finition consiste en une couche d'un métal noble avec un métal tel que Nickel ou Or, Argent, Palladium etc., ou un alliage d'un ou plusieurs de ces métaux, ou une succession de couches d'un ou plusieurs de ces métaux en fonction des besoins. Cette couche de finition protège le support des agressions mécaniques, de l'oxydation, et procure un effet réfléchissant favorable à l'effet d'éclairage généré par l'ensemble. Une telle métallisation finale est flexible : la métallisation peut être réalisée de manière électrolytique ou sans utilisation d'électrode de dépôt selon une technique également appelée « electroless » selon la terminologie anglophone.

En outre , on procède avantageusement au dépôt d'un matériau sur la face de la couche de cuivre 10 qui est opposée à celle portant le film diélectrique 20 tel qu'un matériau de masquage de soudure ou soldermask ou coverlay en Anglais, et qui vient avantageusement pénétrer au moins partiellement dans les sillons 14 réalisés, pour éviter qu'une pâte de brasage ou une résine d'encapsulation du composant électroluminescent ne diffuse à travers le sillon dans les zones non recouvertes par le composant lors de l'assemblage de ce composant avec le support. Le matériau de type soldermask est préférentiellement un matériau laminé sur la face de la couche de cuivre 10 qui est opposée à celle portant le film diélectrique 20 de telle sorte que l'on provoque une pénétration au moins partielle de ce matériau dans les sillons 14 réalisés. Le matériau est préférentiellement un matériau insolable, développable et réticulable thermiquement pour une mise en place aisée et précise de ce dernier.

Dans une étape finale, les composants 51, 52 sont positionnés au sein des cavités 21, 22, en étant fixés et mis en contact avec le fond de chaque cavité lequel est formé par la couche de cuivre 10, ici par l'intermédiaire d'une pate de brasage conductrice disposée sous les plages de contact de ces composants 51, 52 ou par exemple par des fils d'or.

Bien que décrite en référence à la mise en place de composants électroluminescents, l'invention est adaptée à la réalisation de circuits portant des composants à base de semi-conducteurs lesquels n'aient pas de fonction luminescente mais réalisent d'autres fonctions telles que par exemple des fonctions de traitement électrique et/ou de données.

## Revendications

1. Procédé de réalisation de circuit comprenant un support (1), lequel support (1) comprend une couche conductrice (10) et un film diélectrique (20) laminés entre eux, le procédé incluant une étape de réalisation de fenêtres (21,22) dans le film diélectrique (20) de sorte que le support (1) forme des cavités (21,22) ayant une paroi de fond constituée par la couche conductrice (10) et des bordures constituées par le film diélectrique (20), le procédé incluant l'étape consistant à venir placer contre la paroi de fond d'une cavité (21,22) et connecter à la paroi de fond un composant électronique (51,52), le procédé comprenant l'étape consistant à graver des sillons (14) dans la couche conductrice (10), cette étape de gravure de la couche conductrice (10) étant réalisée postérieurement au laminage de la couche conductrice (10) avec le film diélectrique (20) à l'aide d'une solution de gravure et le procédé comprenant une étape préliminaire à l'étape de gravure, laquelle étape préliminaire consiste à déposer une couche de matériau de protection (30) sur la couche conductrice (10) dans le fond de la cavité (21,22) et sur au moins une partie du film diélectrique (20) formant les bordures de la cavité (21,22), lequel matériau de protection (30) est un matériau liquide apte à durcir et résistant une fois durci à la solution de gravure mise en oeuvre lors de l'étape de gravure de la couche conductrice (10).

2. Procédé selon la revendication 1, **caractérisé en ce que** l'étape consistant à venir placer un composant électronique contre la paroi de fond d'une cavité (21,22) et à connecter à la paroi de fond le composant électronique (51,52) comprend le fait de mettre en connexion le composant électronique (51,52) avec la paroi de fond sans liaison filaire intermédiaire.

3. Procédé selon la revendication 1, **caractérisé en ce que** l'étape consistant à venir placer un composant électronique contre la paroi de fond d'une cavité (21,22) et à connecter à la paroi de fond le composant électronique (51,52) comprend le fait de connecter le composant électronique (51,52) à la paroi de fond par une liaison filaire laquelle s'étend du composant électronique à la paroi de fond.

4. Procédé selon l'une quelconque des revendications précédentes, **caractérisé en ce que** le composant électronique (51,52) est un composant électroluminescent.

5. Procédé selon l'une quelconque des revendications précédentes, **caractérisé en ce que** le matériau de protection (30) est une encre.

6. Procédé selon l'une quelconque des revendications 1 à 4, **caractérisé en ce que** le matériau de protection (30) est une résine.

7. Procédé selon l'une quelconque des revendications 1 à 4, **caractérisé en ce que** le matériau de protection (30) est une mélange d'au moins une encre et d'au moins une résine.

8. Procédé selon l'une quelconque des revendications précédentes, **caractérisé en ce que** le matériau de protection (30) fait partie du groupe constitué des polyuréthanes mono ou bi-composants, des résines acryliques ou méthacryliques, des résines acryliques réticulables aux ultra-violets, des copolymères styrène anhydride maléique, des copolymères styrènes acrylique, des copolymères acryliques méthacryliques, des résines formol phénol, des résines novolaque, des résines époxy.

9. Procédé selon l'une quelconque des revendications précédentes, **caractérisé en ce que** le matériau de protection (30) est un matériau apte à être durci par exposition à la lumière et le procédé comprend l'étape consistant à exposer le matériau de protection à la lumière pour le durcir.

10. Procédé selon l'une quelconque des revendications précédentes, **caractérisé en ce qu'**il comprend une étape postérieure à l'étape de gravure qui consiste à enlever la couche de matériau de protection (30).

11. Procédé selon la revendication précédente, **caractérisé en ce que** l'étape consistant à enlever la couche de matériau de protection (30) consiste à plonger le support (1) dans un bain de solution d'attaque chimique de la couche de matériau de protection (30).

12. Procédé selon l'une quelconque des revendications précédentes, **caractérisé en ce que** le matériau de protection (30) est appliqué par une opération faisant partie du groupe constitué d'une pulvérisation, d'une enduction, d'une impression.

13. Procédé selon l'une quelconque des revendications précédentes, **caractérisé en ce que** le circuit (1,51,52) est un circuit de type flexible.

## Patentansprüche

1. Verfahren zur Herstellung einer Schaltung, die einen Träger (1) enthält, wobei der Träger (1) eine leitende Schicht (10) und eine dielektrische Folie (20) enthält, die miteinander laminiert sind, wobei das Verfahren einen Schritt der Herstellung von Fenstern (21, 22) in der dielektrischen Folie (20) umfasst, damit der Träger (1) Hohlräume (21, 22) bildet, die eine aus der leitenden Schicht (10) bestehende Bodenwand und aus der dielektrischen Folie (20) bestehende Ränder haben, wobei das Verfahren den Schritt umfasst, der darin besteht, ein elektronisches Bauteil (51, 52) gegen die Bodenwand eines Hohlraums (21, 22) zu platzieren und mit der Bodenwand zu verbinden, und das Verfahren den Schritt enthält, der darin besteht, Rillen (14) in die leitende Schicht (10) zu ätzen, wobei dieser Ätzschritt der leitenden Schicht (10) nach dem Laminieren der leitenden Schicht (10) mit der dielektrischen Folie (20) mit Hilfe einer Ätzlösung durchgeführt wird, und das Verfahren einen vor dem Ätzschritt liegenden Schritt enthält, wobei der vorherige Schritt darin besteht, eine Schicht von Schutzmaterial (30) auf die leitende Schicht (10) am Boden des Hohlraums (21, 22) und auf mindestens einen Teil der die Ränder des Hohlraums (21, 22) bildenden dielektrischen Folie (20) aufzubringen, wobei das Schutzmaterial (30) ein flüssiges Material ist, das härten kann und, wenn es gehärtet ist, der Ätzlösung widersteht, die im Ätzschritt der leitenden Schicht (10) verwendet wird.

2. Verfahren nach Anspruch 1, **dadurch gekennzeichnet, dass** der Schritt, der darin besteht, ein elektronisches Bauteil gegen die Bodenwand eines Hohlraums (21, 22) zu platzieren und das elektronische Bauteil (51, 52) mit der Bodenwand zu verbinden, die Verbindung des elektronischen Bauteils (51, 52) mit der Bodenwand ohne Zwischendrahtverbindung enthält.

3. Verfahren nach Anspruch 1, **dadurch gekennzeichnet, dass** der Schritt, der darin besteht, ein elektronisches Bauteil gegen die Bodenwand eines Hohlraums (21, 22) zu platzieren und das elektronische Bauteil (51, 52) mit der Bodenwand zu verbinden, die Verbindung des elektronischen Bauteils (51, 52) mit der Bodenwand über eine Drahtverbindung enthält, die sich vom elektronischen Bauteil zur Bodenwand erstreckt.

4. Verfahren nach einem der vorhergehenden Ansprüche, **dadurch gekennzeichnet, dass** das elektronische Bauteil (51, 52) ein Elektrolumineszenzbauteil ist.

5. Verfahren nach einem der vorhergehenden Ansprüche, **dadurch gekennzeichnet, dass** das Schutzmaterial (30) eine Druckfarbe ist.

6. Verfahren nach einem der Ansprüche 1 bis 4, **dadurch gekennzeichnet, dass** das Schutzmaterial (30) ein Harz ist.

7. Verfahren nach einem der Ansprüche 1 bis 4, **dadurch gekennzeichnet, dass** das Schutzmaterial (30) eine Mischung aus mindestens einer Druckfarbe und mindestens einem Harz ist.

8. Verfahren nach einem der vorhergehenden Ansprüche, **dadurch gekennzeichnet, dass** das Schutzmaterial (30) Teil der Gruppe ist, die aus den Ein- oder Zweikomponenten-Polyurethanen, den Acryl- oder Methacrylharzen, den UVvernetzbaren Acrylharzen, den Maleinsäureanhydrid-Styrol-Copolymeren, den Acryl-Styrol-Copolymeren, den Methacryl-Acryl-Copolymeren, den Phenol-FormaldehydHarzen, den Novolac-Harzen, den Epoxidharzen besteht.

9. Verfahren nach einem der vorhergehenden Ansprüche, **dadurch gekennzeichnet, dass** das Schutzmaterial (30) ein Material ist, das durch Lichtexposition gehärtet werden kann, und das Verfahren den Schritt enthält, der darin besteht, das Schutzmaterial dem Licht auszusetzen, um es zu härten.

10. Verfahren nach einem der vorhergehenden Ansprüche, **dadurch gekennzeichnet, dass** es einen Schritt nach dem Ätzschritt enthält, der darin besteht, die Schutzmaterialschicht (30) zu entfernen.

11. Verfahren nach dem vorhergehenden Anspruch, **dadurch gekennzeichnet, dass** der Schritt, der darin besteht, die Schutzmaterialschicht (30) zu entfernen, darin besteht, den Träger (1) in ein Ätzlösungsbad der Schutzmaterialschicht (30) zu tauchen.

12. Verfahren nach einem der vorhergehenden Ansprüche, **dadurch gekennzeichnet, dass** das Schutzmaterial (30) durch einen Vorgang aufgebracht wird, der Teil der Gruppe ist, die aus einer Zerstäubung, einer Beschichtung, einem Druck besteht.

13. Verfahren nach einem der vorhergehenden Ansprüche, **dadurch gekennzeichnet, dass** die Schaltung (1, 51, 52) eine Schaltung vom flexiblen Typ ist.

## Claims

1. Method of production of a circuit including a support (1), which support (1) includes a conductive layer (10) and a dielectric film (20) laminated together, the method including a step of making windows (21, 22) in the dielectric film (20) so that the support (1) forms cavities (21, 22) having a bottom wall formed by the conductive layer (10) and borders formed by the dielectric film (20), the method including the step consisting of an electronic component (51, 52) being placed against the bottom wall of a cavity (21, 22) and being connected to the bottom wall, the method including the step consisting of etching grooves (14) in the conductive layer (10), this step of etching the conductive layer (10) being performed after the lamination of the conductive layer (10) with the dielectric film (20) with the aid of an etching solution and the method including a preliminary step to the step of etching, which preliminary step consists of depositing a layer of protective material (30) on the conductive layer (10) in the bottom of the cavity (21, 22) and on at least one part of the dielectric film (20) forming the borders of the cavity (21, 22), which protective material (30) is a liquid material capable of hardening and once hardened resistant to the etching solution used in the step of etching the conductive layer (10).

2. Method according to Claim 1, **characterized in that** the step consisting of an electronic component being placed against the bottom wall of a cavity (21, 22) and the electronic component (51, 52) being connected to the bottom wall includes connecting the electronic component (51, 52) with the bottom wall without an intermediate wired connection.

3. Method according to Claim 1, **characterized in that** the step consisting of an electronic component being placed against the bottom wall of a cavity (21, 22) and the electronic component (51, 52) being connected to the bottom wall includes connecting the electronic component (51, 52) to the bottom wall via a wire connection which extends from the electronic component to the bottom wall.

4. Method according to any one of the preceding claims, **characterized in that** the electronic component (51, 52) is an electroluminescent component.

5. Method according to any one of the preceding claims, **characterized in that** the protective material (30) is an ink.

6. Method according to any one of Claims 1 to 4, **characterized in that** the protective material (30) is a resin.

7. Method according to any one of Claims 1 to 4, **characterized in that** the protective material (30) is a mixture of at least one ink and at least one resin.

8. Method according to any one of the preceding claims, **characterized in that** the protective material (30) forms part of the group consisting of mono or bi-component polyurethanes, acrylic or methacrylic resins, ultraviolet crosslinkable acrylic resins, styrene-maleic anhydride copolymers, styrene-acrylic copolymers, methacrylic-acrylic copolymers, phenol formaldehyde resins, novolac resins and epoxy resins.

9. Method according to any one of the preceding claims, **characterized in that** the protective material (30) is a material capable of being hardened by exposure to light and the method includes the step consisting of exposing the protective material to light to harden it.

10. Method according to any one of the preceding claims, **characterized in that** it includes a step subsequent to the step of etching which consists of removing the layer of protective material (30).

11. Method according to the preceding claim, **characterized in that** the step consisting of removing the layer of protective material (30) consists of immersing the support (1) in a bath of chemical solution for chemically attacking the layer of protective material (30).

12. Method according to any one of the preceding claims, **characterized in that** the protective material (30) is applied by an operation forming part of the group consisting of spraying, coating and printing.

13. Method according to any one of the preceding claims, **characterized in that** the circuit (1, 51, 52) is a flexible type of circuit.
